(19) Europäisches Patentamt
European Patent Office
Office européen des brevets

(11) **EP 2 312 750 B1**

(12) **EUROPEAN PATENT SPECIFICATION**

(45) Date of publication and mention
of the grant of the patent:
**23.05.2012 Bulletin 2012/21**

(51) Int Cl.:
*H03F 3/191* (2006.01)　　*H03F 13/00* (2006.01)
*H04B 10/12* (2006.01)　　*H03F 99/00* (2009.01)

(21) Application number: **10305324.5**

(22) Date of filing: **30.03.2010**

(54) **A method for transmission of signals from a transmitting device to a receiving device comprising an amplifying unit, a transmitting device and a receiving device therefor**

Verfahren zur Übertragung eines Signals von einer Sendevorrichtung an eine Empfangsvorrichtung mit einer Verstärkereinheit, Sendevorrichtung und Empfangsvorrichtung dafür

Procédé de transmission de signaux depuis un dispositif de transmission à un dispositif de réception comprenant une unité d'amplification, un dispositif de transmission et un dispositif de réception correspondants

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **15.10.2009 EP 09290788**

(43) Date of publication of application:
**20.04.2011 Bulletin 2011/16**

(73) Proprietor: **Alcatel Lucent**
**75007 Paris (FR)**

(72) Inventors:
 • **Templ, Wolfgang**
**74372 Sersheim (DE)**
 • **Wiegner, Dirk**
**71409 Schwaikheim (DE)**

(74) Representative: **Kleinbub, Oliver et al**
**Alcatel-Lucent Deutschland AG**
**Lorenzstr. 10**
**70435 Stuttgart (DE)**

(56) References cited:
　**US-A1- 2003 113 067**　　**US-A1- 2004 001 719**
　**US-A1- 2006 140 644**　　**US-A1- 2009 232 191**

 • **JEAN-PIERRE RASKIN ET AL: "A Novel Parametric-Effect MEMS Amplifier" JOURNAL OF MICROELECTROMECHANICAL SYSTEMS, IEEE SERVICE CENTER, PISCATAWAY, NJ, US, vol. 9, no. 4, 1 December 2000 (2000-12-01), XP011034596 ISSN: 1057-7157**
 • **T-C NGUYEN C ED - KINNICK R R ET AL: "6I-4 Integrated Micromechanical Circuits Fueled By Vibrating RF MEMS Technology (Invited)" ULTRASONICS SYMPOSIUM, 2006. IEEE, IEEE, PI LNKD- DOI:10.1109/ULTSYM.2006.224, 1 October 2006 (2006-10-01), pages 957-966, XP031076428 ISBN: 978-1-4244-0201-4**

## Description

### Field of the invention

The invention relates to a method for transmission of signals from a transmitting device to at least one receiving device comprising at least one amplifying unit for signal amplification, wherein said signals are transmitted over at least one optical connection from the transmitting device to the at least one receiving device, and a transmitting and a receiving device adapted to perform said method.

### Background

The coverage of a certain service area in a cellular radio network is provided by several radio base stations, which are connected to a core network to serve connections to and from mobile users within the service area. A radio base station contains a baseband unit and at least one antenna unit. In order to increase radio coverage and capacity, modern base stations use several sector antennas.

In order to increase flexibility of the base stations, it is desirable to allow the antennas to be located remote from the baseband unit. This has lead to the development of active antenna systems which are also termed remote antenna heads. Typically, one remote antenna head contains one sector antenna, but there are also systems known, which have remote antenna heads with more than only one sector antenna.

The base stations are preferably connected with the remote antenna heads by means of optical fibers. Conventional radio-over-fiber scenarios involve optical transmission of analogue signals between a base station and a transmitter with an amplifier in a remote antenna head.

An example for the implementation of a radio-over-fiber concept in a cellular radio network using a two-fiber-ring is given in the European patent EP 1553791 B1.

However, the quality of the optical transmission suffers severely from noise, non-linearities, like e.g. chromatic dispersion, and attenuation effects. Additionally, signal transmission over wide distances leads e.g. to high losses. Consequently the technical implementations for radio-over-fiber concepts must involve highly sophisticated optical modulation techniques and signal conditioning.

Furthermore, wireless communication systems of the 3rd generation and later (3 G and beyond) use modulation formats which yield radio frequency output signals featuring high peak to average ratios. The amplification of such signals imposes high requirements on power efficiency and linearity to the transmitter line up, especially for the final stage of the power amplifier, where by far the largest share of energy is dissipated.

So called switched amplifiers have a theoretical power efficiency of 100%, going along with high linearity.

A switched amplifier is e.g. known from M. Iwamoto et al., Electronics Letters, 8th June 2000, Vol. 36, No. 12, page 1010-1012. M. Iwa-mato discloses a class S amplifier wherein a bandpass delta-sigma modulator (BPDSM) does a 1-bit A/D (analogue to digital) conversion, generating a fast pulse sequence which is fed into a transistor based switching amplifier. The output signal of the switching amplifier is fed into a bandpass filter for reconstruction purposes.

The physical realization of the switched amplifier concept, however, involves losses and signal distortion e.g. caused by the parasitics of the transistor based switching devices and the reconstruction filter. Examples are parasitic gate capacitance and non-zero on-resistance in the switching field effect transistor, device mismatch between components, and filter losses.

Additionally, the efficiency is often reduced due to limited coding efficiency in case of use of delta-sigma modulators. For the reconstruction filter, in particular in case of a BPDSM based class S amplifier, challenging termination requirements in the stop bands and also low insertion loss in the transmission band have to be guaranteed in order to achieve good class S performance.

It has been proposed to replace a transistor based switching device with an array of nano-switches, thus avoiding disadvantages which are caused by the analogue nature of a transistor, which has originally been designed as a device for amplification of analogue signals. The nano-switches of such an array are switched identically with the fast pulse sequence of the bandpass delta-sigma modulator. However, a reconstruction filter is still necessary, resulting in distortions and losses, and coding efficiency is still limited by the BPDSM.

Finally, e.g. flexibility regarding addressed frequency bands and reconfigurability is an additional important factor, which arises problems for solutions based on conventional amplifier architectures.

### Summary

Basically, the optical transmission of analogue radio frequency signals involves high electronic efforts for signal modulation techniques and signal conditioning. Indeed, e.g. the method of intensity modulation and direct detection is straightforward, simple and allows for fairly linear optical transmission properties, but on the other hand it requires costly modulators and modulator drivers in order to meet the requirements for analogue radio frequency transmission. In case double side band modulation is used, chromatic dispersion will result in frequency and length dependent suppression of radio frequency power, which will deteriorate the transmission quality.

The object of the invention is thus to propose a cost-effective and fault-tolerant method for optical transmission of signals from a transmitting device to a receiving device comprising signal amplification appropriate for multi-band or multi-standard application with high linearity.

This object is achieved by a method for transmission of signals from a transmitting device to at least one receiving device comprising at least one amplifying unit for signal amplification, wherein

• said signals are transmitted over at least one optical connection from the transmitting device to the at least one receiving device,

• electrical signals are converted into optical signals in at least one electro-optical converter located in the transmitting device,

• the optical signals are converted from optical signals into electrical signals in at least one opto-electrical converter that is located in said at least one receiving device,

• the electrical signals are amplified in the at least one amplifying unit with the steps of

 - analysing the spectral components, namely the amplitudes and the phases at different frequencies, of the electrical signals,

 - applying a supply voltage to a coupling array comprising a plurality of nano-sized coupling elements, wherein the coupling elements are grouped into a number N of sub-arrays, with each sub-array exhibiting

  ■ a specific resonance frequency corresponding to a frequency component of the electrical signals,

  ■ and a specific attenuation

 of a mechanical self oscillation of its coupling elements,

 - and stimulating mechanical self-oscillations of the coupling elements of the sub-arrays in dependence of the spectral components of the electrical signals.

The object is furthermore achieved by a transmitting device for transmission of signals to at least one receiving device wherein said transmitting device comprises

• a signal processing unit for controlling stimulating means for stimulating a mechanical self-oscillation in an amplifying unit with stimulating pulses having a pulse form and timing calculated by the signal processing unit based on an evaluation of the spectral components of signals to be amplified, namely the amplitudes and phases at the frequencies corresponding to said specific resonance frequencies,

• at least one electro-optical converter for converting said stimulating pulses from electrical signals into optical signals,

• and at least one optical output that is adapted to transmit said optical signals.

The object is furthermore achieved by a receiving device for reception of signals sent from a transmitting device wherein said receiving device comprises

• at least one optical input that is adapted to receive optical signals,

• at least one opto-electrical converter that is adapted to convert the optical signals into electrical signals,

• and at least one amplifying unit, comprising a coupling array comprising a plurality of nano-sized coupling elements, wherein the coupling elements are grouped into a number N of sub-arrays, with each sub-array exhibiting

  ■ a specific resonance frequency
  ■ and a specific attenuation

of a mechanical self-oscillation of its coupling elements, wherein for the coupling elements of each sub array, there is a stimulating means for stimulating a mechanical self-oscillation.

In other words, in order to address the above-identified problems, it is thus proposed to transmit signals from the digital part of a base station preferably digitally via an optical connection, as e.g. an optical fibre, to a distributed, even far remotely located, amplification stage, followed by an antenna network and an antenna.

As a basic idea of the invention, the radio frequency output signal is generated by composing its frequency components generated by means of nano-sized coupling elements, which act as mechanical oscillators at their resonance frequency each. When excited, each coupling element oscillates at its resonance frequency, and via the change of its coupling during an oscillation, the corresponding frequency component can be generated by modulating an externally applied supply voltage providing electric power. This results in an inherent frequency up-conversion.

With the inventive method, the amplification of RF signals can be done with high efficiency and high linearity. The method exploits the self-resonances of nano-sized coupling elements for generating frequency components of an amplified RF signal.

The exploitation of the self-resonance of the nano-sized coupling elements in the inventive coupling arrays allows for a completely different and disruptive approach for realization of a high efficient radio frequency amplifier: The output signal is generated by the combination of spectral signal components which are generated by the controlled triggered self oscillations of nano-sized coupling elements, i.e. switches. Those coupling elements are grouped in a number of sub-arrays, characterized by specific physical parameters, as e.g. geometrical dimension, material or suspension, of their coupling elements, wherein the physical parameters define the self resonance at a well defined frequency and attenuation. All coupling elements of the same sub-array have the same resonance frequency and the same attenuation, within the limits of the manufacturing tolerance. This concept allows to overcome the current available transmitter architecture in particular by omitting the digital-to-analog converter, such as a bandpass delta-sigma modulator, and the up-conversion module, as well as the lossy and technically challenging reconstruction filter.

The invention combines the benefits of a switched amplifier, namely high efficiency, digital control, and wide band operation, with the benefits of the analogue amplifiers, namely efficient parallel operation of fragmented frequency bands and avoidance of reconstruction filter with its non-idealities and matching losses. By means of the invention, an external reconstruction filter can be avoided together with its related matching circuitry in a switched power amplifier. Different from the class S switched amplifier, the inventive device does not involve sigma delta or comparable modulation. It features 100% coding efficiency. By this it contributes to an improved energy efficiency of the transmitter lineup while maintaining linearity. Additionally, by increasing the number of sub-arrays, the supported signal bandwidth can be large, and is in particular not limited by a digital-to-analog converter.

In general, each coupling element comprises a first mobile part and an opposing second part relative to which the first mobile part may mechanically oscillate, i.e. vibrate. Note that the second opposing part may also be mobile. The distance or overlap of the two parts determines the degree of coupling of the coupling element, which varies during the mechanical self oscillation of the coupling element. Typically, in a non-oscillating state, i.e. home state, of a coupling element, the coupling is low and preferably practically zero. Preferably, the coupling elements are designed such that said two parts of the coupling element keep a spatial separation even in a tight coupling state in which their coupling is at its maximum, thus reducing wear. The coupling is typically based on electron emission or tunnelling effect; this results in a continuous dependency of the coupling with the distance or overlap of the parts of the coupling element.

A single coupling element, in accordance with the invention, typically has a maximum dimension of 1 $\mu$m or less. A mobile part of a coupling element typically has a maximum dimension of 800 nm or less. The dimensions of a coupling element are also chosen with respect to the material from which the coupling element or its mobile part is made. Note that there are in general a few hundreds or even thousands of coupling elements per sub-array, in order to be able to generate a high power RF output signal.

Typically, each coupling element has a separate stimulating means such as a piezo-electric coating; however, it is also possible to have a common stimulation means for a plurality of coupling elements of the same sub-array, e.g. when the stimulation means acts at a common suspension of the coupling elements.

**Preferred variants of the invention**

In a highly preferred embodiment of the invention, the radio frequency power amplifier comprises a number N of stimulating impulse generators, wherein each stimulating impulse generator controls the stimulating means of a sub-array, and wherein the stimulating impulse generators are controlled by the signal processing unit. An impulse generator may amplify a stimulating pulse of the signal processing unit and/or adapt it to the needs of the stimulating means of the connected sub-array. The impulse generators may be realized as piezo drivers, for example.

In a further preferred embodiment, the power amplifier comprises a feedback loop for analysing an RF output signal of the coupling array by the signal processing unit. By means of the feedback loop, the timing and shape of the stimulating pulses may be optimized to get a true amplified reconstruction of the signal to be amplified.

In a highly preferred embodiment, the stimulating means comprise a piezoelectric element, in particular a piezoelectric coating on a coupling element or part of a coupling element. With the piezoelectric element, a control voltage pulse may be transformed into a mechanical stimulus by simple means. A piezoelectric coating, in accordance with the invention, may be a plane one-sided coating of a first part of a coupling element, such as a first reed, wherein an applied voltage causes the first part of the coupling element to bend, e.g. upwards in case its upper side coating is piezoelectrically contracted by means of electrostriction. After the mechanical stimulus, the coupling element oscillates, i.e. swings, freely at its resonance frequency. The coupling of the first part to an opposing second part of the coupling element, such as a second reed, which is dependent on the distance of the two parts, varies during the self oscillation and thus allows to generate a signal with a frequency component of said resonance frequency.

A preferred embodiment provides that a coupling element comprises two parallel, opposing and partially overlapping reeds. Reeds are simple oscillators, whose resonance frequency is easy to calculate. In particular, nano-sized reeds may be produced by cost-efficient lithographic processes.

In a preferred further development of this embodiment, the two reeds are designed to keep a spatial separation even in a tight coupling state. This reduces wear. Note that also for other types of coupling elements, it is preferred to have a contact-less tight coupling.

In another embodiment, a coupling element comprises a membrane arranged opposite to a coupling surface, wherein during mechanical self oscillation, the distance between the membrane and the coupling surface varies. The membrane and the coupling surface may act as electron emission surface and receiver surface, or the other way around. By means of a membrane, larger overlap areas may be realized, allowing higher signal power generation. Note that the membrane material must be chosen adequately with respect to the desired resonance frequency.

Further, in an embodiment, a coupling element comprises

- a torsion unit with a first coupling surface covering only part of the torsion unit's circumference, and
- a jacket which at least partially houses the torsion unit, wherein the jacket comprises second coupling surface covering only part of the jacket's inner circumference. The coupling surfaces act as electron emission or receiver surfaces respectively. In the home state of the torsion unit, the coupling is typically low. The torsion unit may rotatively swing with respect to the jacket with one end of the torsion unit, whereas the opposing end remains fixed. By means of a torsion unit and jacket, the degree of coupling between a low coupling state, e.g. the home state, and a high coupling state can be varied particularly strongly.

In an advantageous embodiment of the inventive RF power amplifier, the coupling elements within the same sub-array have the same physical dimension and properties, thus featuring the same mechanical resonance frequency. By choosing identically designed coupling elements within each sub-array, the design may be particularly simple, and sharp resonances can be realized. Note that identical design of the coupling elements also results in the same attenuation of the mechanical self-oscillations.

Also within the scope of the present invention is the use of an inventive RF power amplifier in a telecommunication system, in particular in a base station of a mobile communication network. The inventive RF power amplifier can be used, in particular, in mobile telephony.

Further advantageous is the use of an inventive RF power amplifier in a fragmented transceiver architecture. Said fragmented transceiver architecture may in particular be used in telecommunication system applications. In the fragmented transceiver architecture, several RF power amplifiers are used in parallel, with each RF power amplifier handling its own frequency interval. Since the sub-arrays are already specialized for particular frequencies, the cooperation of inventive power amplifiers dedicated to different frequency bands is particularly simple and efficient.

In a preferred variant of the inventive method, the mechanical self-oscillations are stimulated also in dependence of an RF output signal of the coupling array. Thus a better precision in the reconstruction of the amplified RF signal can be achieved.

Further preferred is a variant wherein the amplification gain is regulated by the fraction of coupling elements of each sub-array which are stimulated. With this variant, the amplification gain of the inventive amplification method is simple to set. Further, said setting of the amplification gain is highly linear and efficient. Typically, the power of the RF input signal to be amplified is constant. Note that for this variant, each coupling element or at least groups of coupling elements of the same sub-array are equipped with separately controllable stimulating means.

Further developments of the invention can be gathered from the dependent claims and the following description. The features mentioned above and below can be used in accordance with the invention either individually or collectively in any combination. The embodiments mentioned are not to be understood as exhaustive enumeration but rather have exemplary character for the description of the invention.

In the following the invention will be explained further making reference to the attached drawings.

## Brief description of the figures

Fig. 1a shows schematically a coupling array of an inventive RF power amplifier with coupling elements based on switching reeds.

Fig. 1b shows a coupling element of Fig. 1a in a home state.

Fig. 1c shows a coupling element of Fig. 1a in a deflected state of increased coupling.

Fig. 2 shows schematically an embodiment of an inventive RF power amplifier, integrated in a transmitter arrangement and based on a coupling array comparable to the one shown in Fig. 1a.

Fig. 3 shows schematically a switching reed of the embodiment of Fig. 1a, with a piezoelectric coating.

Fig. 4 shows schematically a coupling element for an inventive RF power amplifier, based on a membrane.

Fig. 5 shows schematically a coupling element for an inventive RF power amplifier, based on a torsion element and a jacket.

Fig. 6 schematically shows a cellular communication network with a base station and remote antenna heads in which the invention can be implemented.

Fig. 7 schematically shows a transmitting device comprising a digital modulator linked by an optical connection with a receiving device comprising two amplifying units according to an embodiment of the invention.

Fig. 8 schematically shows a transmitting device comprising a digital modulator linked by an optical connection with a receiving device comprising two amplifying units with a common signal processing unit according to an embodiment of the invention.

Fig. 9 schematically shows a transmitting device comprising a digital modulator and a common signal processing unit linked by an optical connection with a receiving device comprising two amplifying units according to an embodiment of the invention.

Fig. 10 schematically shows a transmitting device comprising a digital modulator and a common signal processing unit controlling a plurality of stimulating impulse generators via separate signal paths according to an embodiment of the invention.

**Description of the embodiments**

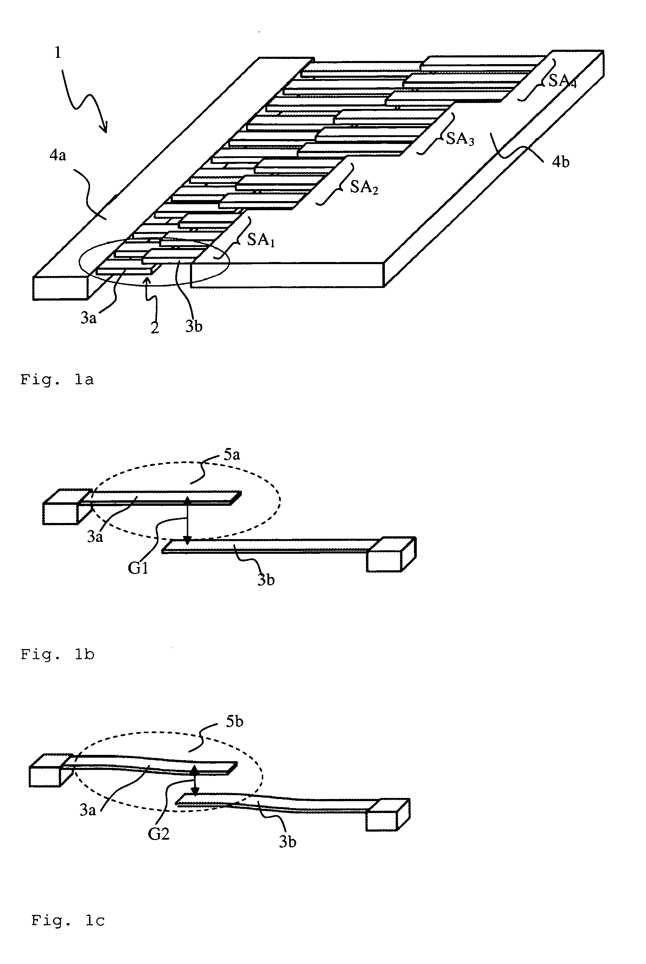

Fig. 1a illustrates in a schematic, perspective view a coupling array 1 for an inventive RF power amplifier.

The coupling array 1 comprises a plurality of nano-sized coupling elements 2, here each with a first switching reed 3a and a second switching reed 3b, arranged separate and opposite to each other, but with some overlap in the region of their free ends (see Fig. 1b and 1c for more details). The ends of the reeds 3a, 3b facing away form the other reed 3a, 3b are fixed to a suspension 4a, 4b each; here common suspensions 4a, 4b for all reeds 3a, 3b of each respective one side of the coupling array 1 are used. The reeds 3a, 3b may oscillate with their free ends, perpendicularly to their shortest dimension, i.e. up and down in Fig. 1a.

The coupling elements 2 are grouped in sub-arrays $SA_1$-$SA_4$. In the schematic illustration of Fig. 1a, four sub-arrays $SA_1$-$SA_4$ with each sub-array $SA_1$-$SA_4$ having three coupling elements 2 are shown for simplicity; however in practical implementations there are much more sub-arrays (typically a thousand or more) and much more coupling elements per sub-array (typically several thousands). The number N of sub-arrays and the number of coupling elements 2 per sub-array depends on the required bandwidth, the required frequency resolution, the required signal output power and the electrical characteristics of the coupling contacts.

Within each sub-array $SA_1$-$SA_4$, the coupling elements 2 have the same physical dimensions and properties, and therefore exhibit the same resonance fre-

quency $f_1$-$f_4$ and the same attenuation (within the manufacturing tolerance). In the example shown, the length of the reeds 3a, 3b increases from the first (front) sub-array $SA_1$ to the last (rear) sub-array $SA_4$, giving the coupling array 1 a harp-like design.

Since each sub-array (or group) of coupling elements ("switches") represents a distinct resonance frequency given by

$$\omega \propto \sqrt{\frac{E}{\rho}}\frac{d}{l^2}$$

 (with E = Young's modulus, p = specific mass, d = thickness of reed, 1 = length of reed, $\omega=2\pi f$), there is a plurality of N sub-arrays (only four of which are shown in Fig. 1a, namely $SA_1$-$SA_4$) to compose the wanted RF output signal from its frequency components $\omega_n$, with n=1...N, wherein N is the number of discrete frequency component bins in the RF signal to be amplified. Note that in this way the frequency up-conversion is performed inherently, because the self oscillation frequencies of the structure are centred at the RF carrier.

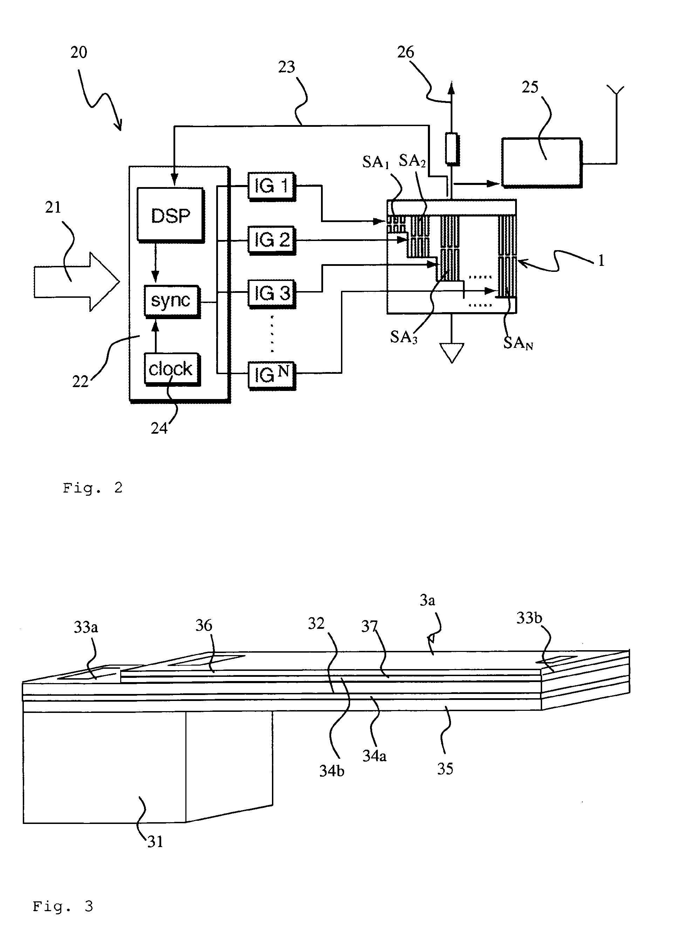

A coupling element 2 may be triggered to a self oscillation by an ultra-short electrical impulse, which is converted into a mechanical stimulating impulse through piezoelectric conversion, enabled by an appropriate piezo-active coating of the contact reeds (see Fig. 3).

The oscillation of the reeds 3a, 3b of a coupling element 2 (compare Fig. 1, oval marking) is illustrated in Figs. 1b and 1c.

In Fig. 1b, a home state (undeflected state) of the reeds 3a, 3b is shown. In the example shown, the left reed 3a is connected to the negative pole, and the right reed 3b is connected to the positive pole of a constant voltage supply (not shown). In the undeflected state, the reeds 3a, 3b are separated by a relatively large gap G1, and accordingly, the electric field strength between the reeds 3a, 3b is relatively low. As a result, there is only a low (and practically negligible) electron emission current form reed 3a to reed 3b. In Fig. 1b, there is also indicated an area 5a around the reed 3a in which significant electron tunneling to an opposing (neighboring) reed may occur at the given voltage. Since the reed 3b is outside the area 5a, there is also no significant tunneling current from reed 3a to reed 3b. In summary, in the undeflected state of Fig. 1b, there is only a low and practically zero coupling of the reeds 3a, 3b.

Fig. 1c shows the reeds 3a, 3b in a deflected state, wherein the reeds 3a, 3b have approached each other with their free ends (the free end of reed 3a is bent downwards, and the free end of reed 3b is bent upwards); this approached state is reached during each self oscillation of the reeds (note that the reeds 3a, 3b here oscillate at the same frequency and at a fixed phase shift of 180°). The remaining gap G2 is relatively small as compared to G1, and typically in the order of only a few nanometers. In accordance with the relatively small gap G2, the electric field strength between the reeds 3a, 3b has increased. As a result, there is an increased electron emission current from reed 3a to reed 3b, as compared to the undeflected state of Fig. 1b. In order to increase the electron emission current, the reeds 3a and/or 3b may be made from or coated with a material of low or negative electron affinity (e.g. diamond). Further, the area 5b around reed 3a in which significant electron tunneling may occur from reed 3a to an opposing reed has been bent downward towards the reed 3b, such that the free end of reed 3b is now within the area 5b; therefore a significant tunneling current will flow from reed 3a to reed 3b. In summary, in the deflected state of Fig. 1c, there is a good coupling between the reeds 3a and 3b and thus a good electrical conductivity between the two reeds 3a, 3b for a supplied voltage and a corresponding power current, respectively.

Fig. 2 shows an exemplary embodiment of the electrical setup of the inventive RF power amplifier 20.

The RF power amplifier 20 comprises a signal processing unit 22, which receives information 21 about the spectral components (i.e. frequencies $f_1$ ... $f_N$, amplitudes $C_1$ ... $C_N$ and phases $\Phi_1$ ... $\Phi_N$) of an RF or baseband input signal to be amplified (Note that in accordance with the invention, it is also possible to have an analyzing unit integrated in a signal processing unit wherein the analyzing unit identifies the spectral components of an RF input signal to be amplified which is directly fed to the signal processing unit). With this information 21, the signal processing unit 22 calculates the pulse form and timing for stimulating pulses. In the example shown, this information is sent to stimulating impulse generators $IG_1$ ... $IG_N$, with one stimulating impulse generator $IG_1$...$IG_N$ for each sub-array $SA_1$...$SA_N$ of the coupling array 1. The stimulating impulse generators $IG_n$ create stimulating pulses for their respective sub-array $SA_n$ each, based on the pulse form and timing information from the signal processing unit 22. The amplitude of the stimulating pulse determines the power of the spectral component and the timing determines its phasing. The calculation of the pulse form and timing is based on the spectral input information on baseband level, a fed back sample (see feedback loop 23) of the RF output signal, and a reference clock 24. The resonance frequencies $f_1$...$f_N$ of the coupling elements within the sub-arrays $SA_1$...$SA_N$ are fixed and correspond to the frequencies of the analyzed spectral components of the RF input signal. In the example shown, the RF output signal is fed into an antenna network 25.

The supply voltage (electrical power) applied at supply input 26, here a direct current (dc) supply voltage, is lead through the coupling array 1, facing a resistance in dependence of the coupling within the sub-arrays $SA_1$-$SA_N$ of the coupling elements incorporated therein. The sub-arrays $SA_1$-$SA_N$ are electrically connected in parallel.

As an example, an inventive RF power amplifier 20 may apply a frequency resolution in equal steps of between 1 kHz and 50 kHz, with a typical width of a resolved frequency interval of between 1 MHz and 50 MHz. The center frequency of the RF input signal to be amplified is typically between 500 MHz and 10 GHz. For example, with a frequency resolution of 50 kHz and a width of 50 MHz, the coupling array 1 comprises about 1000 sub-arrays, i.e. N=1000.

Fig. 3 shows in a schematic, perspective view the layer structure (coating structure) of a reed 3a as shown in Fig. 1a, by way of example. On a coupler contact 31 (which may be part of the suspension 4a in Fig. 1a), the reed 3a is mounted at one (left) end; the other (right) end extends freely away from the coupler contact 31.

The base structures of the reed 3a here are a layer (or coating) supporting electron emission 35 ("emission layer") and a piezoactive layer (or coating) 32. The emission layer 35 is directly attached to the coupler contact 31 to electrically connect the emission layer 35 to a voltage supply (not shown) and faces the other reed (compare Fig. 1b for example, reed 3b). The emission layer 35 and the piezoactive layer 32 are separated by an insulating layer 34a, such as an oxide layer. On top of the piezoactive layer 32, there is another insulating layer 34b and a metallization 37.

The piezoactive layer 32 may be electrically contacted at its left (exposed) end via a first piezo contact 33a, and at its right (covered) end via a second (window) contact 33b reaching through the upper insulating layer 34b. The second (window) contact 33b is electrically connected via the metallization 37 to a metallization contact 36 in the region of the coupler contact 31 such that the areas of immediate connection to an external piezo voltage supply, namely the first contact 33a and the metallization contact 36, are well reachable and are not exposed to deflection during a reed oscillation.

By applying a voltage across the piezo-electric coating 32, the piezo-electric coating 32 may e.g. be contracted whereas the emission layer 35 remains at its original length, resulting in an upward-bending of the reed 3b at its free right end. After the voltage application has ended, the reed 3a will oscillate at its resonance frequency, causing a coupling varying with the resonance frequency. Note that the reed 3a may comprise an additional layer, in particular in order to deposit both the emission layer and the piezoactive layer as coatings on the additional layer, and/or to better control the mechanical properties (such as the resonance frequency via a dominant specific mass) of the reed 3a. It is also noted that piezo-electric multilayer structures may be applied instead of a single piezoactive layer 32. Note that the resonance frequency of a coupling element and here are reed 3a, in accordance with the invention, is typically in the GHz range.

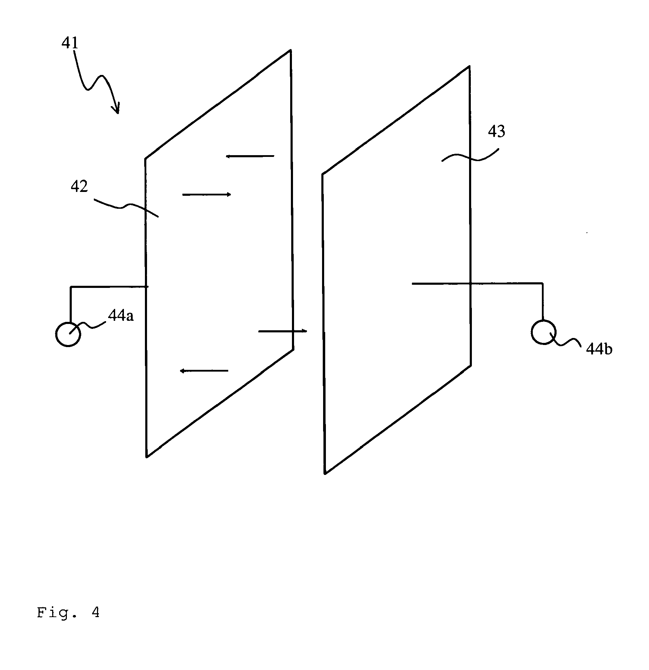

Fig. 4 shows a simple membrane-based coupling element 41. The coupling element 41 comprises a membrane 42 arranged opposite to a stiff coupling surface 43 (note that alternatively the coupling surface 43 may be realized on another movable membrane). The membrane 42 may oscillate at its resonance relative to the coupling surface 43, e.g. in the way indicated by the arrows. As a result, electrical current flowing through the coupling element 41 (see electrical contacts 44a, 44b) will oscillate with a frequency corresponding to the resonance frequency of the membrane 42. In order to initiate the self oscillation, the membrane 42 has a piezoelectric coating (not shown).

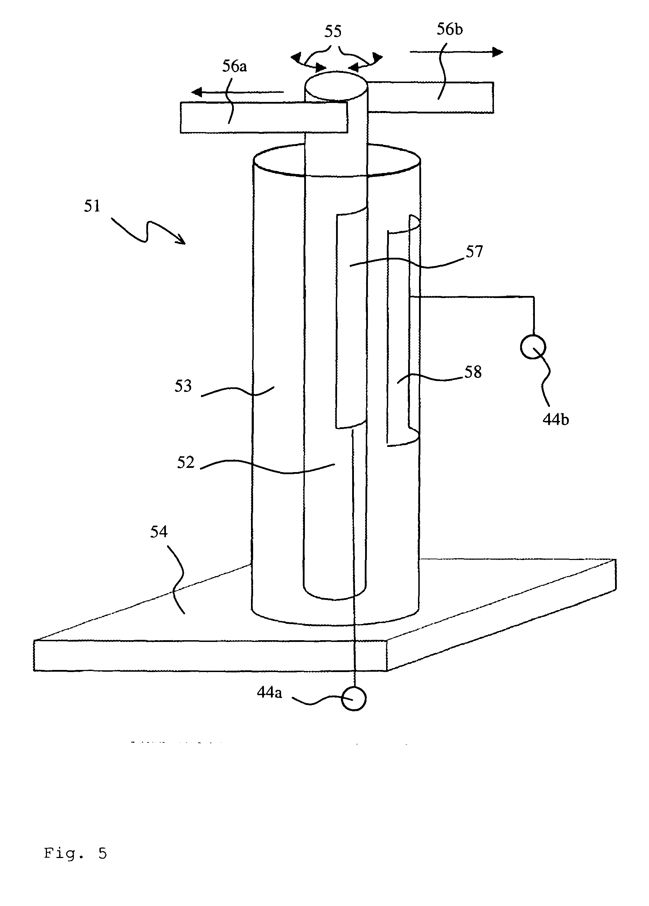

Fig. 5 illustrates a further coupling element 51, based on a torsion unit 52 and a jacket 53. On a fixed mounting 54, the torsion unit 52 (here of a rod-type shape) and the jacket 53, which surrounds the torsion unit 52, are fixed with their lower ends. The torsion unit 52, or more specifically its upper end, may be twisted (elastically rotated) around its vertical axis (see arrows 55); upon a deflection, the torsion unit 52 will exhibit a torsion oscillation at its resonance frequency. A torsion oscillation may be triggered by means of a two-part torsion impulsion (drive) 56a, 56b.

On the outer surface of the torsion unit 52, there is a first coupling surface 57, which covers about one third of the torsion unit's circumference. Further, on the inner surface of the jacket 53, there is a second coupling surface 58, covering about one tenth of the inner surface's circumference. The first coupling surface 57 and the second coupling surface 58 have about the same area size here. The coupling surfaces 57, 58 are connected to a power supply and an RF signal output (see contacts 44a, 44b). During an oscillation, the two coupling surfaces 57, 58 vary their overlap (and distance), and thus the coupling varies with the resonance frequency of the torsion oscillation.

The proposed invention realizes a highly efficient and highly linear power amplifier which furthermore does not require a D/A converter and an up-conversion module any more, in contrast to state of-the-art RF power transmitter architectures. Moreover, a reconstruction filter is not required with the inventive RF power amplifier. A large signal bandwidth can more easily be supported by simply increasing the number of sub-arrays. Additionally, fragmented transceiver architecture (parallel operation of fragmented frequency bands) becomes feasible, without decreasing efficiency, as this is true for conventional wide-band amplifiers, e.g. based on Class-AB operation.

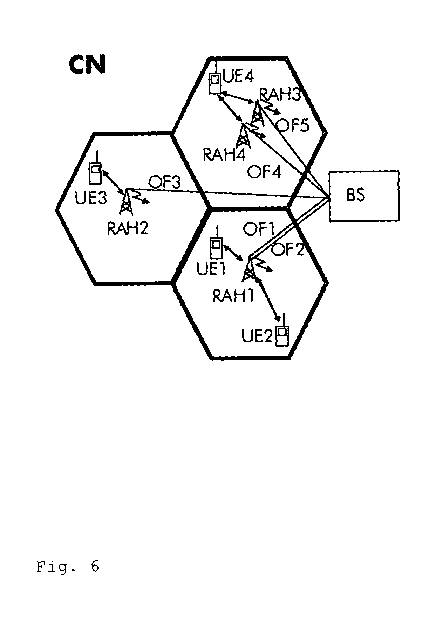

The principle structure of a communication network CN for signal transmission and reception in which the invention can be implemented is shown in fig. 6. The communication network CN comprises a base station BS, remote antenna heads RAH1-RAH4 and user terminals UE1-UE4.

Each of said remote antenna heads RAH1-RAH4 is connected to the base station BS by means of at least one optical connection, as e.g. an optical fiber or an optical free-space connection, OF1, OF2, OF3, OF4 and OF5 respectively. Each of said user terminals UE1-UE4 is connected to one or multiple of said remote antenna heads RAH1-RAH4, which is symbolized by double arrows in fig. 1. The base station BS is in turn connected to a core network, which is not shown in fig. 1 for the sake of simplicity.

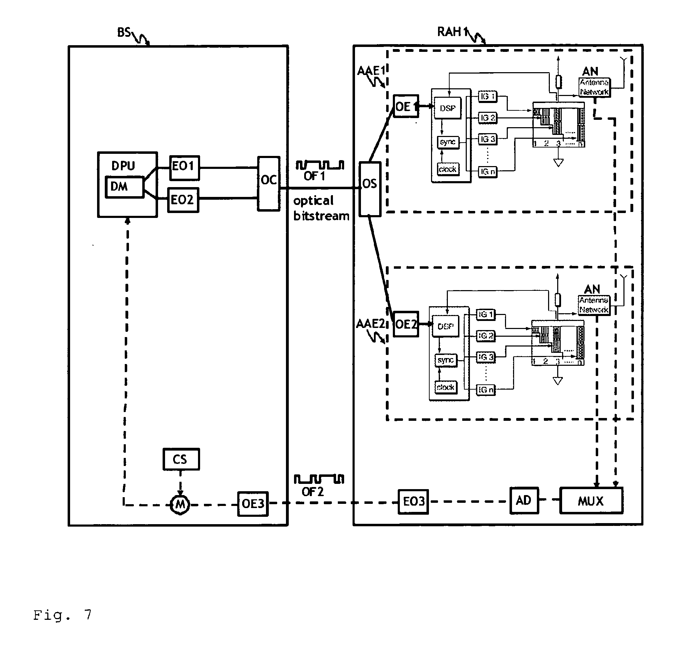

A transmitting device BS, as e.g. a base station, and a receiving device RAH1, as e.g. a remote antenna head, according to an embodiment of the invention are depicted in fig. 7.

The transmitting device BS is indicated as a box and comprises a digital signal processing unit DPU with a digital modulator DM, a first and a second electro-optical converter E01 and E02, and an optical combiner OC.

The receiving device RAH1 is also indicated as a box and comprises an optical splitter OS, and two so-called active antenna elements AAE1 and AAE2, which are identical in construction. Each of said two active antenna elements AAE1 and AAE2 is indicated by a dashed box and comprises an opto-electrical converter OE1, OE2, and an amplifying unit as depicted in fig. 2.

A first output of the digital modulator DM is connected to an input of the first electro-optical converter E01. An output of the first electro-optical converter E01 is connected to a first input of the optical combiner OC.

A second output of the digital modulator DM is connected to an input of the second electro-optical converter E02. An output of the second electro-optical converter E02 is connected to a second input of the optical combiner OC.

An output of the optical combiner OC is connected to an input of the optical splitter OS through an optical connection OF1, as e.g. an optical fiber or an optical free-space connection.

A first output of the optical splitter OS is connected to the input of the opto-electrical converter OE1 of the first active antenna element AAE1, and a second output of the optical splitter OS is connected to the input of the opto-electrical converter OE2 of the second active antenna element AAE2.

As the active antenna elements AAE1 and AAE2 are identical in construction, the connections of the components of only one active antenna element are described in the following.

An output of the first opto-electrical converter OE1 is connected to an input of a digital signal processor DSP of the amplifying unit whose structure is described above under fig. 2.

In the digital modulator DM, two sets of electrical data signals e.g. for beamforming or multiple-input-multiple-output that the digital modulator DM receives at its input are digitally modulated on baseband level resulting in two sets of electrical digital data signals of e.g. so-called I and Q data used e.g. in the standard Third Generation Partnership Project Long Term Evolution (3GPP LTE).

The first set of electrical digital data signals is sent to the input of the first electro-optical converter EO1.

In the first electro-optical converter E01, the first set of electrical digital data signals is converted into optical digital data signals on a first optical carrier wavelength, and transmitted to the first input of the optical combiner OC.

The second set of electrical digital data signals is sent to the input of the second electro-optical converter E02.

In the second electro-optical converter E02, the second set of electrical digital data signals is converted into optical digital data signals on a second optical carrier wavelength, and transmitted to the second input of the optical combiner OC.

Preferably, each of said first and second electro-optical converters E01 and E02 comprises a laser diode which is either directly modulated or externally modulated e.g. by means of a electroabsorption or lithiumniobate modulator.

In an embodiment of the invention, instead of a single digital modulator, two digital modulators are used for processing different user information. The first digital modulator is connected to the input of the first electro-optical converter E01, and the second digital modulator is connected to the input of the second electro-optical converter E02. The further processing of the different user information, which is comprised in the two sets of electrical data signals, is as described in the following for the case of a single digital modulator.

The optical digital data signals on the first optical carrier wavelength and the optical digital data signals on the second optical carrier wavelength are transmitted to the input of the optical splitter OS located in the receiving device RAH1 via the optical connection OF1, which can be e.g. an optical fiber or an optical free-space connection. In the optical splitter OS, the optical digital data signals on the first optical carrier wavelength, and the optical digital data signals on the second optical carrier wavelength are separated based on the optical carrier wavelength and transmitted to the input of the opto-electrical converter OE1 of the first active antenna element AAE1 and of the opto-electrical converter OE2 of the second active antenna element AAE2 respectively.

In the first opto-electrical converter OE1, the optical digital data signals are back-converted into electrical digital data signals. Preferably, said opto-electrical converter OE1 comprises a so-called PIN-diode or a so-called avalanche-photodiode.

From the first opto-electrical converter OE1, the electrical digital data signals are sent to the input of the digital signal processor DSP of the amplifying unit. The further processing of the electrical digital data signals is as described above under fig. 2.

The two active antenna elements AAE1 and AAE2 can be combined with further active antenna elements to an active antenna array.

In the following, an embodiment is described for linearization of the amplifying unit, which is also depicted in fig. 7.

In the embodiment of the invention, the transmitting device BS further comprises a mixer M, a carrier synthesizer CS, and a third opto-electrical converter OE3, and the receiving device RAH1 further comprises a multiplexer MUX, an analogue-to-digital converter AD, and a third electro-optical converter E03.

The embodiment for linearization of the amplifying unit is based on a feedback of a sample of the amplified electrical data signals. The amplified electrical data signals are tapped e.g. at the antenna network AN.

The tapped electrical analogue data signals of the first and the second active antenna elements AAE1, AAE2 are fed to the multiplexer MUX in which the electrical analogue data signals of the first and the second active antenna elements AAE1, AAE2 are time-multiplexed. The electrical analogue data signals are transmitted from the multiplexer MUX to the analogue-to-digital converter AD, in which the electrical analogue data signals are converted into electrical digital data signals.

Afterwards the electrical digital data signals are converted into optical digital data signals in the third electro-optical converter E03, and are transmitted via an optical connection OF2, as e.g. an optical fiber or an optical free-space connection to the third opto-electrical converter OE3 located in the transmitting device BS, in which the optical digital data signals are converted back into electrical digital data signals.

Then the electrical digital data signals are sent via a reconstruction filter, which is not shown in fig. 2, to the mixer M in which they are downconverted to baseband level by means of electrical analogue radio frequency carrier signals generated in the carrier synthesizer CS.

Finally, the downconverted electrical analogue data signals are fed to the digital signal processing unit DPU for baseband linearization. The digital signal processing unit DPU in this embodiment additionally comprises an anti-aliasing filter and an analogue-to-digital converter, which are not shown in fig. 2, for filtering and conversion into the digital domain of the downconverted electrical analogue data signals.

In a variant of the embodiment, not the tapped electrical analogue data signals are transmitted back to the digital signal processing unit DPU, but merely a control information for baseband linearization which has been calculated in the receiving device RAH1.

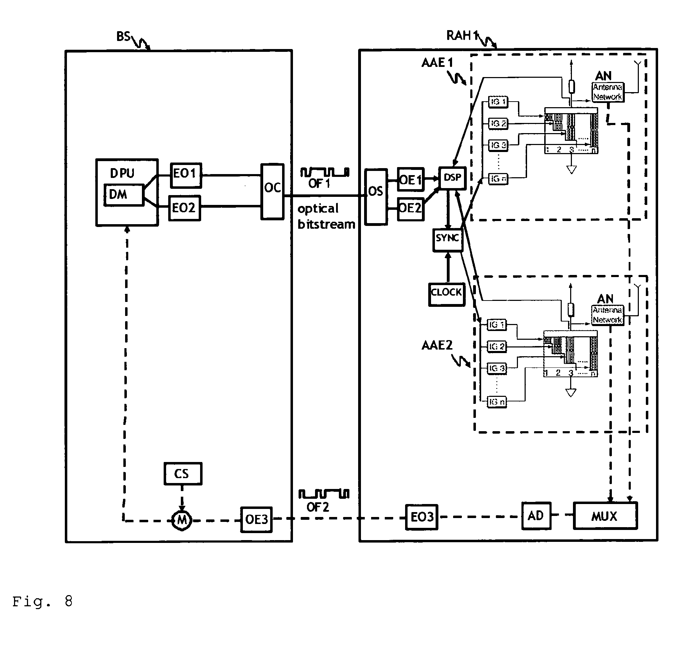

In another embodiment of the invention, which is depicted in fig. 8, there is a common signal processing unit for the two amplifying units in the receiving device RAH1 comprising a digital signal processor DSP, a synchronizing unit SYNC and a reference clock CLOCK.

The principle structure is similar to the one depicted in fig. 7, so that only the differences are described in the following.

Compared to the embodiment depicted in fig. 7, instead of individual signal processing units in each active antenna element AAE1 and AAE2, there is a common signal processing unit for the two amplifying units in the receiving device RAH1 comprising a digital signal processor DSP, a synchronizing unit SYNC and a reference clock CLOCK.

Both the first and the second opto-electrical converter OE1 and OE2 are connected to the digital signal processor DSP. The digital signal processor DSP has inputs for receiving feedback samples of RF output signals from the amplifying units of both active antenna elements AAE1 and AAE2 for calibration of the amplifying units. The digital signal processor DSP is furthermore connected to the synchronizing unit SYNC.

The synchronizing unit SYNC is in turn connected to the reference clock CLOCK, and to the stimulating impulse generators IG1-IGn of both amplifying units.

Both sets of electrical data signals sent from the first and the second opto-electrical converter OE1 and OE2 respectively are analyzed in the digital signal processor DSP in order to determine the spectral components. Alternatively, the sets of electrical data signals may already comprise information about the spectral components.

The calculation of the pulse form and timing is based on the spectral input information on baseband level, i.e. the spectral components, a fed back sample of the RF output signal, and the reference clock CLOCK as described above under fig. 2. The respective information for generation of the calculated pulses is sent from the synchronizing unit SYNC to the stimulating impulse generators IG1-IGn of both amplifying units.

In variants of the embodiments described above under fig. 7 and 8, instead of modulated electrical digital data signals on baseband level, signals comprising information about the spectral components, i.e. frequencies $f_1 ... f_N$, amplitudes $C_1 ...C_N$ and phases $\Phi_1 ... \Phi_N$, of an RF signal to be amplified are sent from the transmitting device BS to the digital signal processor of the receiving device RAH1.

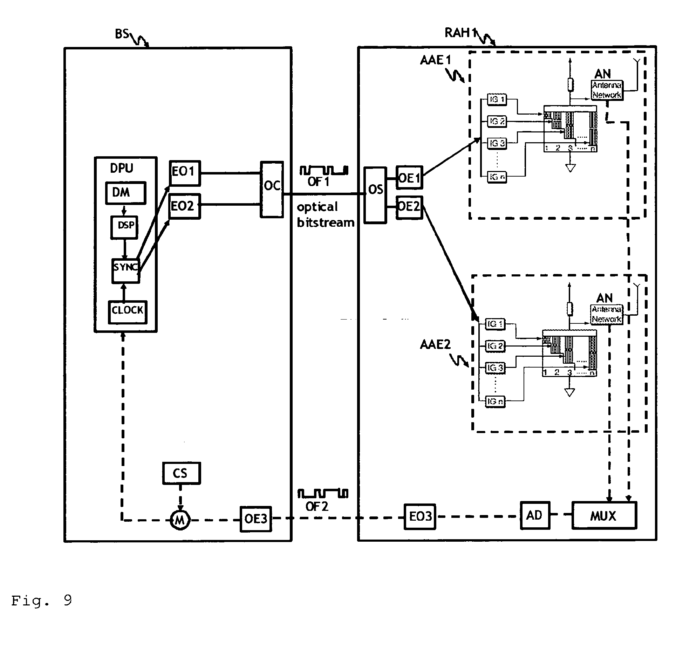

In yet another embodiment of the invention, which is depicted in fig. 9, there is a common signal processing unit for the two amplifying units in the transmitting device BS comprising a digital signal processor DSP, a synchronizing unit SYNC and a reference clock CLOCK.

The principle structure is similar to the one depicted in fig. 8, so that only the differences are described in the following.

Compared to the embodiment depicted in fig. 8, the common signal processing unit for the two amplifying units in the receiving device RAH1 comprising a digital signal processor DSP, a synchronizing unit SYNC and a reference clock CLOCK is located in the transmitting device BS and not in the receiving device RAH1.

The digital modulator DM is connected to the digital signal processor DSP, which is in turn connected to the synchronizing unit SYNC.

The synchronizing unit SYNC is connected to the reference clock CLOCK, and to the first and second electro-optical converter E01 and E02.

In the receiving device, the first and the second opto-electrical converter OE1 and OE2 are connected to the stimulating impulse generators IG1-IGn of the first and the second active antenna element AAE1 and AAE2 respectively.

Both sets of electrical data signals sent from the digital modulator DM are analyzed in the digital signal processor DSP in order to determine the spectral components for both sets of electrical data signals.

The calculation of the pulse form and timing is based on the spectral input information on baseband level, i.e. the spectral components, a fed back sample of the RF output signal received via the dashed feedback path, and the reference clock CLOCK as described above under fig. 2. The respective information for generation of the calculated pulses for the first and the second set of electrical data signals is sent from the synchronizing unit SYNC to the first and the second electro-optical converter E01 and E02 respectively.

In the receiving device, the respective information for generation of the calculated pulses for the first and the second set of electrical data signals is sent to the stimulating impulse generators IG1-IGn of the first active antenna element AAE1 via the first opto-electrical converter OE1, and to the stimulating impulse generators IG1-IGn of the second active antenna element AAE2 via the second opto-electrical converter OE2 respectively.

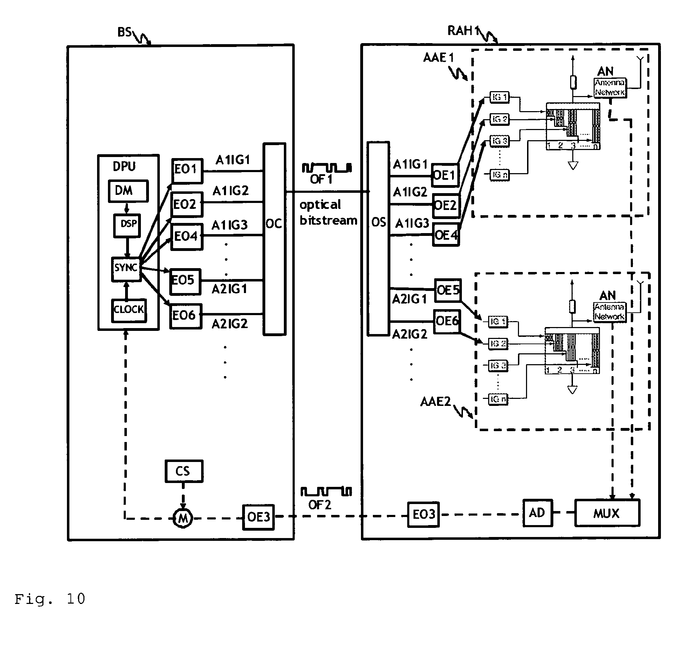

In an even further embodiment of the invention, which is depicted in fig. 10, there is a common signal processing unit for the two amplifying units in the transmitting device BS comprising a digital signal processor DSP, a synchronizing unit SYNC, and a reference clock CLOCK, and a separate signal path A1IG1, A1IG2...A2IG1, A2IG2... for the control of each stimulating impulse generator IG1-IGn of both active antenna elements AAE1 and AAE2.

The principle structure is similar to the one depicted in fig. 9, so that only the differences are described in the following.

Compared to the embodiment depicted in fig. 9, there is a dedicated electro-optical converter E01, E02, E04... and a dedicated opto-electrical converter OE1, OE2, OE4... for controlling each stimulating impulse generator IG1-IGn of both active antenna elements AAE1 and AAE2 separately.

From the synchronizing unit SYNC, the respective information for generation of the calculated pulses is sent to each of the stimulating impulse generators IG1-IGn via separate signal paths A1IG1, A1IG2...A2IG1, A2IG2... with separate electro-optical converters E01, E02, E04... and separate opto-electrical converters OE1, OE2, OE4...

In the embodiments described above, two active antenna elements are used for signal transmission. However, the principal idea of the invention can also be applied to systems with more than two active antenna elements or with only one active antenna element.

## Claims

1. A method for transmission of signals from a transmitting device (BS) to at least one receiving device (RAH1) comprising at least one amplifying unit for signal amplification, wherein said signals are transmitted over at least one optical connection (OF1) from the transmitting device (BS) to the at least one receiving device (RAH1) **characterized in, that**

   • electrical signals are converted into optical signals in at least one electro-optical converter (EO1, E02) located in the transmitting device (BS),
   • the optical signals are converted from optical signals into electrical signals in at least one opto-electrical converter (OE1) that is located in said at least one receiving device (RAH1),
   • and the electrical signals are amplified in the at least one amplifying unit with the steps of

   - analysing the spectral components, namely the amplitudes $(C_1...C_N)$ and the phases $(\Phi_1...\Phi_N)$ at different frequencies $(f_1...f_N)$, of the electrical signals,
   - applying a supply voltage to a coupling array (1) comprising a plurality of nano-sized coupling elements (2; 41; 51), wherein the coupling elements (2; 41; 51) are grouped into a number N of sub-arrays $(SA_1...SA_N)$, with each sub-array $(SA_1...SA_N)$ exhibiting

     ■ a specific resonance frequency $(f_1...f_N)$ corresponding to a frequency component $(f_1...f_N)$ of the electrical signals,
     ■ and a specific attenuation

   of a mechanical self oscillation of its coupling elements (2; 41; 51),
   - and stimulating mechanical self-oscillations of the coupling elements (2; 41; 51) of the sub-arrays $(SA_1...SA_N)$ in dependence of the spectral components of the electrical signals.

2. A method according to claim 1, **characterized in, that** the mechanical self-oscillations are stimulated also in dependence of an output signal of the coupling array (1).

3. A method according to claim 1 or 2, **characterized in, that** the amplification gain is regulated by the fraction of coupling elements (2; 41; 51) of each sub-array $(SA_1...SA_N)$ which are stimulated.

4. A transmitting device (BS) for transmission of signals to at least one receiving device (RAH1) **character-**ized in, that said transmitting device (BS) comprises

   • a signal processing unit (22) for controlling stimulating means for stimulating a mechanical self-oscillation in an amplifying unit with stimulating pulses having a pulse form and timing calculated by the signal processing unit (22) based on an evaluation of the spectral components of signals to be amplified, namely the amplitudes $(C_1...C_N)$ and phases $(\Phi_1...\Phi_N)$ at the frequencies $(f_1...f_N)$ corresponding to said specific resonance frequencies,
   • at least one electro-optical converter (EO1, E02) for converting said stimulating pulses from electrical signals into optical signals,
   • and at least one optical output that is adapted to transmit said optical signals.

5. A transmitting device (BS) according to claim 4, **characterized in, that** said transmitting device (BS) is a base station (BS) for transmission of signals via a remote antenna head (RAH1) to a user terminal (UE1).

6. A receiving device (RAH1) for reception of signals sent from a transmitting device (BS) **characterized in, that** said receiving device (RAH1) comprises

   • at least one optical input that is adapted to receive optical signals,
   • at least one opto-electrical converter (OE1) that is adapted to convert the optical signals into electrical signals,
   • and at least one amplifying unit, comprising a coupling array (1) comprising a plurality of nano-sized coupling elements (2; 41; 51), wherein the coupling elements (2; 41; 51) are grouped into a number N of sub-arrays $(SA_1...SA_N)$, with each sub-array $(SA_1...SA_N)$ exhibiting

     ■ a specific resonance frequency $(f_1...f_N)$
     ■ and a specific attenuation of a mechanical self-oscillation of its coupling elements (2; 41; 51), wherein for the coupling elements (2; 41; 51) of each sub array $(SA_1...SA_N)$, there is a stimulating means for stimulating a mechanical self-oscillation.

7. A receiving device (RAH1) according to claim 6, **characterized in, that** the at least one amplifying unit comprises a signal processing unit (22) for controlling the stimulating means with stimulating pulses having a pulse form and timing calculated by the signal processing unit (22) based on an evaluation of the spectral components of signals to be amplified, namely the amplitudes $(C_1...C_N)$ and phases $(\Phi_1...\Phi_N)$ at the frequencies $(f_1...f_N)$ corresponding to said specific resonance frequencies.

**8.** A receiving device (RAH1) according to claim 6, **characterized in, that** the at least one amplifying unit comprises a number N of stimulating impulse generators ($IG_1...IG_N$), wherein each stimulating impulse generator ($IG_1...IG_N$) controls the stimulating means of a sub-array ($SA_1...SA_N$), and wherein the stimulating impulse generators ($IG_1...IG_N$) are controlled by at least one signal processing unit (22).

**9.** A receiving device (RAH1) according to claim 6, **characterized in, that** the stimulating means comprise a piezoelectric element, in particular a piezoelectric coating (32) on a coupling element (2; 41; 51) or part of a coupling element (2; 41; 51).

**10.** A receiving device (RAH1) according to claim 6, **characterized in, that** a coupling element (2) comprises two parallel, opposing and partially overlapping reeds (3a, 3b).

**11.** A receiving device (RAH1) according to claim 10, **characterized in, that** the two reeds (3a, 3b) are designed to keep a spatial separation even in a tight coupling state.

**12.** A receiving device (RAH1) according to claim 6, **characterized in, that** a coupling element (41) comprises a membrane (42) arranged opposite to a coupling surface (43), wherein during mechanical self oscillation, the distance between the membrane (42) and the coupling surface (43) varies.

**13.** A receiving device (RAH1) according to claim 6, **characterized in, that** a coupling element (51) comprises

• a torsion unit (52) with a first coupling surface (57) covering only part of the torsion unit's circumference,
• and a jacket (53) which at least partially houses the torsion unit (52), wherein the jacket (53) comprises second coupling surface (58) covering only part of the jacket's inner circumference.

**14.** A receiving device (RAH1) according to claim 6, **characterized in, that** the coupling elements (2; 41; 51) within the same sub-array ($SA_1...SA_N$) have the same physical dimension and properties, thus featuring the same mechanical resonance frequency ($f_1...f_N$).

**15.** A receiving device (RAH1) according to claim 6, **characterized in, that** said receiving device (RAH1) is a remote antenna head for reception of signals sent from a base station (BS).

**Patentansprüche**

**1.** Verfahren zur Übertragung von Signalen von einer Sendevorrichtung (BS) an mindestens eine Empfangsvorrichtung (RAH1) mit mindestens einer Verstärkereinheit zur Signalverstärkung, wobei die besagten Signale über mindestens eine optische Verbindung (OF1) von der Sendevorrichtung (BS) an die mindestens eine Empfangsvorrichtung (RAH1), **dadurch gekennzeichnet, dass**

• elektrische Signale in mindestens einem in der Sendevorrichtung (BS) angeordneten elektro-optischen Wandler (EO1, E02) in optische Signale umgewandelt werden,
• die optischen Signale in mindestens einem in der besagten mindestens einen Empfangsvorrichtung (RAH1) angeordneten opto-elektrischen Wandler (OE1) von optischen Signalen in elektrische Signale umgewandelt werden,
• und die elektrischen Signale in der mindestens einen Verstärkereinheit verstärkt werden, wobei die folgenden Schritte durchgeführt werden:

- Analysieren der Spektralkomponenten, und zwar der Amplituden ($C_1....C_N$) und der Phasen ($\Phi_1...\Phi_N$) in unterschiedlichen Frequenzen ($f_1...f_N$), der elektrischen Signale,
- Anlegen einer Versorgungsspannung an eine Kopplungsanordnung (1) mit einer Mehrzahl von Kopplungselementen im Nanogrößenbereich (2; 41; 51), wobei die Kopplungselemente (2; 41; 51) in eine Anzahl N von Teilanordnungen ($SA_1...SA_N$) gruppiert sind, wobei jede Teilanordnung ($SA_1...SA_N$) aufweist:

• Eine spezifische Resonanzfrequenz ($f_1...f_N$), welche einer Frequenzkomponente ($f_1...f_N$) der elektrischen Signale entspricht,
• und eine spezifische Dämpfung einer mechanischen Eigenschwingung ihrer Kopplungselemente (2; 41; 51),

- und Stimulieren von mechanischen Eigenschwingungen der Kopplungselemente (2; 41; 51) der Teilanordnungen ($SA_1...SA_N$) in Abhängigkeit von den Spektralkomponenten der elektrischen Signale.

**2.** Verfahren nach Anspruch 1, **dadurch gekennzeichnet, dass** die mechanischen Eigenschwingungen ebenfalls in Abhängigkeit von einem Ausgangssignal der Kopplungsanordnung (1) stimuliert werden.

**3.** Verfahren nach Anspruch 1 oder 2, **dadurch ge-**

**kennzeichnet, dass** die Verstärkung durch den Anteil von Kopplungselementen (2; 41; 51) einer jeden Teilanordnung (SA$_1$...SA$_N$), welche stimuliert werden, geregelt wird.

4. Sendevorrichtung (BS) zur Übertragung von Signalen an mindestens eine Empfangsvorrichtung (RAH1), **dadurch gekennzeichnet, dass** die besagte Sendevorrichtung (BS) umfasst:

  • Eine Signalverarbeitungseinheit (22) zur Steuerung von Stimulationsmitteln zum Stimulieren einer mechanischen Eigenschwingung in einer Verstärkereinheit mit Stimulationspulsen, die eine von der Signalverarbeitungseinheit (22) auf der Basis einer Bewertung der spektralen Komponenten von zu verstärkenden Signalen, und zwar der Amplituden (C$_1$...C$_N$) und Phasen ($\Phi_1$...$\Phi_N$) in den Frequenzen (f$_1$...f$_N$), welche den besagten spezifischen Resonanzfrequenzen entsprechen, berechnete Pulsform und Zeitvorgabe aufweisen,
  • mindestens einen elektro-optischen Wandler (E01, E02) zum Umwandeln der besagten Stimulationspulse von elektrischen Signalen in optische Signale,
  • und mindestens einen optischen Ausgang, welcher für die Übertragung der besagten optischen Signale ausgelegt ist.

5. Sendevorrichtung (BS) nach Anspruch 4, **dadurch gekennzeichnet, dass** die besagte Sendevorrichtung (BS) eine Basisstation (BS) für die Übertragung von Signalen über einen entfernten Antennenkopf (RAH1) an ein Benutzerendgerät (UE1) ist.

6. Empfangsvorrichtung (RAH1) für den Empfang von von einer Sendevorrichtung (BS) gesendeten Signalen, **dadurch gekennzeichnet, dass** die besagte Empfangsvorrichtung (RAH1) umfasst:

  • Mindestens einen optischen Eingang, welcher für den Empfang von optischen Signalen ausgelegt ist,
  • mindestens einen opto-elektrischen Wandler (OE1), welcher für die Umwandlung der optischen Signale in elektrische Signale ausgelegt ist,
  • und mindestens eine Verstärkereinheit, umfassend eine Kopplungsanordnung (1) mit einer Mehrzahl von Kopplungselementen im Nanogrößenbereich (2; 41; 51), wobei die Kopplungselemente (2; 41; 51) in eine Anzahl N von Teilanordnungen (SA$_1$...SA$_N$) gruppiert sind, wobei jede Teilanordnung (SA$_1$...SA$_N$) aufweist:

    • Eine spezifische Resonanzfrequenz (f$_1$...$_f$N)

  • und eine spezifische Dämpfung

einer mechanischen Eigenschwingung ihrer Kopplungselemente (2; 41; 51), wobei für die Kopplungselemente (2; 41; 51) einer jeden Teilanordnung (SA$_1$...SA$_N$) ein Stimulationsmittel für die Stimulation einer mechanischen Eigenschwingung vorgesehen ist.

7. Empfangsvorrichtung (RAH1) nach Anspruch 6, **dadurch gekennzeichnet, dass** die mindestens eine Verstärkereinheit eine Signalverarbeitungseinheit (22) zur Steuerung der Stimulationsmittel mit Stimulationspulsen, die eine von der Signalverarbeitungseinheit (22) auf der Basis einer Bewertung der spektralen Komponenten von zu verstärkenden Signalen, und zwar der Amplituden (c$_1$...c$_N$) und Phasen ($\Phi_1$...$\Phi_N$) in den Frequenzen (f$_1$...f$_N$), welche den besagten spezifischen Resonanzfrequenzen entsprechen, berechnete Pulsform und Zeitvorgabe aufweisen, umfasst.

8. Empfangsvorrichtung (RAH1) nach Anspruch 6, **dadurch gekennzeichnet, dass** die mindestens eine Verstärkereinheit eine Anzahl N von Stimulationsimpulserzeugem (IG$_1$...IG$_N$) umfasst, wobei jeder Stimulationsimpulserzeuger (IG$_1$...IG$_N$) die Stimulationsmittel einer Teilanordnung (SA$_1$...SA$_N$) steuert, und wobei die Stimulationsimpulserzeuger (IG$_1$...IG$_N$) von mindestens einer Signalverarbeitungseinheit (22) gesteuert werden.

9. Empfangsvorrichtung (RAH1) nach Anspruch 6, **dadurch gekennzeichnet, dass** die Stimulationsmittel ein piezoelektrisches Element, insbesondere eine piezoelektrische Beschichtung (32) auf einem Kopplungselement (2; 41; 51) oder einem Teil eines Kopplungselements (2; 41; 51) umfassen.

10. Empfangsvorrichtung (RAH1) nach Anspruch 6, **dadurch gekennzeichnet, dass** ein Kopplungselement (2) zwei parallele, sich gegenüberliegende und teilweise überlappende Kontaktzungen (3a, 3b) umfasst.

11. Empfangsvorrichtung (RAH1) nach Anspruch 10, **dadurch gekennzeichnet, dass** die beiden Kontaktzungen (3a, 3b) dazu bestimmt sind, eine räumliche Trennung, selbst in einem engen Kopplungszustand, zu gewährleisten.

12. Empfangsvorrichtung (RAH1) nach Anspruch 6, **dadurch gekennzeichnet, dass** eine Kopplungselement (41) eine Membran (42) umfasst, welche gegenüber einer Kopplungsfläche (43) angeordnet ist, wobei der Abstand zwischen der Membran (42) und der Kopplungsfläche (43) während der mechanischen Eigenschwingung variiert.

**13.** Empfangsvorrichtung (RAH1) nach Anspruch 6, **dadurch gekennzeichnet, dass** ein Kopplungselement (51) umfasst:

· Eine Torsionseinheit (52) mit einer ersten Kopplungsfläche (57), welche nur einen Teil des Umfangs der Torsionseinheit abdeckt,
· und eine Ummantelung (53), welche zumindest teilweise die Torsionseinheit (52) aufnimmt, wobei die Ummantelung (53) eine zweite Kopplungsfläche (58) umfasst, welche nur einen Teil des Innenumfangs der Ummantelung abdeckt.

**14.** Empfangsvorrichtung (RAH1) nach Anspruch 6, **dadurch gekennzeichnet, dass** die Kopplungselemente (2; 41; 51) innerhalb einer selben Teilanordnung ($SA_1$...$SA_N$) dieselbe physikalische Größe und dieselben Eigenschaften besitzen und folglich dieselbe mechanische Resonanzfrequenz ($f_1$...$f_N$) aufweisen.

**15.** Empfangsvorrichtung (RAH1) nach Anspruch 6, **dadurch gekennzeichnet, dass** die besagte Empfangsvorrichten (RAH1) ein entfernter Antennenkopf für den Empfang von von einer Basisstation (BS) gesendeten Signalen ist.

**Revendications**

**1.** Procédé de transmission de signaux depuis un dispositif de transmission (BS) vers au moins un dispositif de réception (RAH1) comprenant au moins une unité d'amplification pour l'amplification de signaux, dans lequel lesdits signaux sont transmis sur au moins une connexion optique (OF1) depuis le dispositif de transmission (BS) vers l'au moins un dispositif de réception (RAH1) **caractérisé en ce que**

· des signaux électriques sont convertis en signaux optiques dans au moins un convertisseur électro-optique (E01, E02) placé dans le dispositif de transmission (BS),
· les signaux optiques sont convertis en signaux électriques dans au moins un convertisseur opto-électrique (OE1) qui est placé dans ledit au moins un dispositif de réception (RAH1),
· et les signaux électriques sont amplifiés dans l'au moins une unité d'amplification avec les étapes suivantes

- analyser les composantes spectrales, à savoir les amplitudes ($c_1$....$c_N$) et les phases ($\Phi_1$...$\Phi_N$) à différentes fréquences ($f_1$... $f_N$), des signaux électriques,
- appliquer une tension d'alimentation à un réseau de couplage (1) comprenant une pluralité d'éléments de couplage nanométriques (2 ; 41 ; 51), les éléments de couplage (2 ; 41 ; 51) étant groupés en un nombre N de sous-réseaux ($SA_1$...$SA_N$), chaque sous-réseau ($SA_1$...$SA_N$) présentant

· une fréquence de résonance spécifique ($f_1$... $f_N$) correspondant à une composante de fréquence ($f_1$...$f_N$) des signaux électriques,
· et une atténuation spécifique d'une auto-oscillation mécanique de ses éléments de couplage (2 ; 41 ; 51),

- et stimuler des auto-oscillations mécaniques des éléments de couplage (2 ; 41 ; 51) des sous-réseaux ($SA_1$...$SA_N$) en fonction des composantes spectrales des signaux électriques.

**2.** Procédé selon la revendication 1, **caractérisé en ce que** les auto-oscillations mécaniques sont également stimulées en fonction d'un signal de sortie du réseau de couplage (1).

**3.** Procédé selon la revendication 1 ou 2, **caractérisé en ce que** le gain d'amplification est régulé par la fraction d'éléments de couplage (2 ; 41 ; 51) de chaque sous-réseau ($SA_1$...$SA_N$) qui sont stimulés.

**4.** Dispositif de transmission (BS) pour la transmission de signaux vers au moins un dispositif de réception (RAH1) **caractérisé en ce que** ledit dispositif de transmission (BS) comprend

· une unité de traitement de signaux (22) pour commander des moyens de stimulation destinés à stimuler une auto-oscillation mécanique dans une unité d'amplification avec des impulsions de stimulation présentant une forme d'impulsion et une synchronisation d'impulsions calculées par l'unité de traitement de signaux (22) sur la base d'une évaluation des composantes spectrales de signaux à amplifier, à savoir les amplitudes ($c_1$...$c_N$) et les phases ($\Phi_1$...$\Phi_N$) aux fréquences ($f_1$...$f_N$) correspondant auxdites fréquences de résonance spécifiques,
· au moins un convertisseur électro-optique (E01, E02) pour convertir lesdites impulsions de stimulation de signaux électriques en signaux optiques,
· et au moins une sortie optique qui est adaptée pour transmettre lesdits signaux optiques.

**5.** Dispositif d'émission (BS) selon la revendication 4, **caractérisé en ce que** ledit dispositif d'émission (BS) est une station de base (BS) destinée à la transmission de signaux à un terminal d'utilisateur (UE1) par l'intermédiaire d'une tête d'antenne distante (RAH1).

6. Dispositif de réception (RAH1) pour la réception de signaux envoyés depuis un dispositif de transmission (BS) **caractérisé en ce que** ledit dispositif de réception (RAH1) comprend

   • au moins une entrée optique qui est adaptée pour recevoir des signaux optiques,
   • au moins un convertisseur opto-électrique (0E1) qui est adapté pour convertir les signaux optiques en signaux électriques,
   • et au moins une unité d'amplification, comprenant un réseau de couplage (1) comprenant une pluralité d'éléments de couplage nanométriques (2 ; 41 ; 51), les éléments de couplage (2 ; 41 ; 51) étant groupés en un nombre N de sous-réseaux $(SA_1...SA_N)$, chaque sous-réseau $(SA_1...SA_N)$ présentant

      • une fréquence de résonance spécifique $(f_1...f_N)$
      • et une atténuation spécifique

   d'une auto-oscillation mécanique de ses éléments de couplage (2 ; 41 ; 51), dans lequel pour les éléments de couplage (2 ; 41 ; 51) de chaque sous-réseau $(SA_1...SA_N)$, il existe un moyen de stimulation destiné à stimuler une auto-oscillation mécanique.

7. Dispositif de réception (RAH1) selon la revendication 6, **caractérisé en ce que** l'au moins une unité d'amplification comprend une unité de traitement de signaux (22) pour commander les moyens de stimulation avec des impulsions de stimulation présentant une forme d'impulsion et une synchronisation d'impulsions calculées par l'unité de traitement de signaux (22) sur la base d'une évaluation des composantes spectrales de signaux à amplifier, à savoir les amplitudes $(c_1...c_N)$ et les phases $(\Phi_1...\Phi_N)$ aux fréquences $(f_1...f_N)$ correspondant auxdites fréquences de résonance spécifiques.

8. Dispositif de réception (RAH1) selon la revendication 6, **caractérisé en ce que** l'au moins une unité d'amplification comprend un nombre N de générateurs d'impulsions de stimulation $(IG_1...IG_N)$, dans lequel chaque générateur d'impulsions de stimulation $(IG_1...IG_N)$ commande les moyens de stimulation d'un sous-réseau $(SA_1...SA_N)$, et dans lequel les générateurs d'impulsions de stimulation $(IG_1...IG_N)$ sont commandés par au moins une unité de traitement de signaux (22).

9. Dispositif de réception (RAH1) selon la revendication 6, **caractérisé en ce que** les moyens de stimulation comprennent un élément piézoélectrique, en particulier un revêtement piézoélectrique (32) sur un élément de couplage (2 ; 41 ; 51) ou sur une partie d'un élément de couplage (2 ; 41 ; 51).

10. Dispositif de réception (RAH1) selon la revendication 6, **caractérisé en ce qu'**un élément de couplage (2) comprend deux lames parallèles, opposées et qui se chevauchent partiellement (3a, 3b).

11. Dispositif de réception (RAH1) selon la revendication 10, **caractérisé en ce que** les deux lames (3a, 3b) sont conçues pour conserver une séparation spatiale même dans un état de couplage étroit.

12. Dispositif de réception (RAH1) selon la revendication 6, **caractérisé en ce qu'**un élément de couplage (41) comprend une membrane (42) disposée à l'opposé d'une surface de couplage (43), dans lequel durant une auto-oscillation mécanique, la distance entre la membrane (42) et la surface de couplage (43) varie.

13. Dispositif de réception (RAH1) selon la revendication 6, **caractérisé en ce qu'**un élément de couplage (51) comprend

    • une unité de torsion (52) avec une première surface de couplage (57) couvrant seulement une partie de la circonférence de l'unité de torsion,
    • et une gaine (53) qui renferme au moins partiellement l'unité de torsion (52), dans lequel la gaine (53) comprend une deuxième surface de couplage (58) couvrant seulement une partie de la circonférence intérieure de la gaine.

14. Dispositif de réception (RAH1) selon la revendication 6, **caractérisé en ce que** les éléments de couplage (2 ; 41 ; 51) à l'intérieur du même sous-réseau $(SA_1...SA_N)$ présentent la même dimension et les mêmes propriétés physiques, présentant ainsi la même fréquence de résonance mécanique $(f_1...f_N)$.

15. Dispositif de réception (RAH1) selon la revendication 6, **caractérisé en ce que** ledit dispositif de réception (RAH1) est une tête d'antenne distante pour la réception de signaux envoyés depuis une station de base (BS).

Fig. 1a

Fig. 1b

Fig. 1c

Fig. 2

Fig. 3

Fig. 4

Fig. 5

Fig. 6

Fig. 7

Fig. 8

Fig. 9

Fig. 10

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1553791 B1

**Non-patent literature cited in the description**

- **M. Iwamoto et al.** *Electronics Letters,* 08 June 2000, vol. 36 (12), 1010-1012